# EUROPÄISCHE PATENTSCHRIFT

(11) **EP 2 486 163 B1**
(45) Veröffentlichungstag und Bekanntmachung des Hinweises auf die Patenterteilung: **11.01.2017**
(21) Anmeldenummer: 10771052.7
(22) Anmeldetag: 06.10.2010
(51) Int. Cl.: C23C 14/32, B22F 1/02, H05H 1/34

(54) **ATMOSPHÄRENDRUCKPLASMAVERFAHREN ZUR HERSTELLUNG OBERFLÄCHENMODIFIZIERTER PARTIKEL UND VON BESCHICHTUNGEN**
ATMOSPHERIC PRESSURE PLASMA METHOD FOR PRODUCING SURFACE-MODIFIED PARTICLES AND COATINGS
PROCÉDÉ À PLASMA À PRESSION ATMOSPHÉRIQUE POUR FABRIQUER DES PARTICULES MODIFIÉES EN SURFACE ET DES REVÊTEMENTS

(30) Priorität: 06.10.2009 DE 102009048397
(43) Veröffentlichungstag der Anmeldung: 15.08.2012
(73) Patentinhaber: Fraunhofer-Gesellschaft zur Förderung der angewandten Forschung e.V., 80686 München (DE); PlasmaTreat GmbH, 33803 Steinhagen (DE)
(72) Erfinder: IHDE, Jörg, 28865 Lilienthal (DE); WILKEN, Ralph, 26180 Rastede (DE); DEGENHARDT, Jost, 28201 Bremen (DE); KNOSPE, Alexander, 33803 Steinhagen (DE); BUSKE, Christian, 33803 Steinhagen (DE)
(74) Vertreter: Hoffmann Eitle
(86) Internationale Anmeldenummer: PCT/EP2010/064906
(87) Internationale Veröffentlichungsnummer: WO 2011/042459

(56) Entgegenhaltungen:
- WO-A2-02/43905
- DE-A1- 10 223 865
- DE-A1- 19 958 473
- DE-U1- 29 911 974
- US-A- 4 488 031
- US-A- 5 514 349
- RODRIGO FERNÁNDEZ-PACHECO ET AL: "Highly magnetic silica-coated iron nanoparticles prepared by the arc-discharge method", NANOTECHNOLOGY, IOP, BRISTOL, GB, Bd. 17, Nr. 5, 14. März 2006 (2006-03-14), Seiten 1188-1192, XP020104519, ISSN: 0957-4484, DOI: DOI:10.1088/0957-4484/17/5/004

## Beschreibung

### GEBIET DER ERFINDUNG

Die vorliegende Erfindung betrifft gemäß einem ersten Aspekt ein Atmosphärendruckplasmaverfahren zur Herstellung oberflächenmodifizierter Partikel. Mit dem Verfahren können auf einfache Weise oberflächenmodifizierte, beispielsweise beschichtete Partikel, insbesondere beschichtete Mikro- und Nanopartikel gebildet werden. Gemäß einem weiteren Aspekt betrifft die Erfindung ein Atmosphärendruckplasmaverfahren zur Herstellung von Beschichtungen mit darin dispergierten Partikeln, insbesondere Mikro- und Nanopartikeln. Die erfindungsgemäßen Verfahren sind deswegen besonders einfach, weil dabei die Partikel, deren Oberfläche modifiziert oder die in eine Beschichtung eingebaut werden sollen, in situ durch Absputtern von mindestens einer der Elektroden erzeugt werden, zwischen denen die Entladung brennt, durch die das Plasma erzeugt wird. Gemäß einem weiteren Aspekt betrifft die Erfindung Plasmadüsen, insbesondere Atmosphärendruckplasmadüsen, und Vorrichtungen, die die Durchführung der erfindungsgemäßen Verfahren ermöglichen und dafür besonders angepasst sind.

### STAND DER TECHNIK

Mikro- und Nanopartikel finden seit einigen Jahren Einsatz in verschiedensten Gebieten der Technik, um die Eigenschaften von Produkten zu modifizieren. Beispielsweise können durch den Einbau solcher Partikel optische, elektrische (z.B. Leitfähigkeit), thermische (z.B. Wärmeleitfähigkeit), elektromagnetische und mechanische Eigenschaften (wie Stabilität, Abriebfestigkeit) verbessert werden. Für die möglichst gute Einbindung der Mikro- und Nanopartikel in die diversen Matrizes ist es von Vorteil, die Oberfläche der Partikel zu modifizieren. Beispielsweise können sie mit einer Beschichtung versehen werden. Auf diese Weise lässt sich häufig die Kompatibilität zwischen Matrix und Partikeln verbessern.

Um die Nachfrage nach beschichteten Partikeln sowie Schichten, in die Partikel dispergiert sind, zu befriedigen, wurden zahlreiche Verfahren vorgeschlagen.

Hier sind zunächst einmal die Niederdruckverfahren zu nennen.

Die DE-A-198 24 364 betrifft beispielsweise ein Verfahren zum Aufbringen von Verschleißschutzschichten mit optischen Eigenschaften auf Oberflächen. Das Verfahren umfasst mindestens zwei unterschiedliche Abscheideschritte. Der eine Schritt ist ein plasmagestützter CVD-Prozess zur Abscheidung einer Verschleißschutz-Matrix und der andere Schritt ist eine Stoffabscheidung mittels einer PVD-Technik zur Einlagerung optisch funktionalen Materials in die Matrix. Die eingesetzte PVD-Technik kann beispielsweise ein Sputterverfahren sein.

Die WO 2005/061754 betrifft ein Verfahren zur Herstellung einer Funktionsschicht, wobei ein Abscheidungsmaterial unter dem Einfluss eines Plasmas auf einem Substrat abgeschieden wird und gleichzeitig mindestens ein zweites Material mit Hilfe eines zweiten Abscheidungsverfahrens auf das Substrat aufgebracht wird. Als zweites Abscheidungsverfahren wird unter anderem PVD, wie beispielsweise Sputtern, genannt.

Die WO 2005/048708 beschäftigt sich mit einem antimikrobiellen und nicht-cytotoxischen Schichtmaterial, das eine Biozid-Schicht und eine diese Schicht bedeckende Transportkontrollschicht umfasst. In Ausführungsbeispiel 6 der Schrift wird die Biozid-Schicht durch einen Niederdruck-DC-Magnetron-Sputter-Prozess und die Transportkontrollschicht in einem zweiten Arbeitsschritt durch einen Plasmapolymerisationsprozess aufgebracht.

Alle Niederdruckverfahren stellen hohe apparative Anforderungen, da Vakuumkammern benötigt werden, ermöglichen üblicherweise nur geringe Abscheideraten (im Bereich von wenigen nm/s) und machen Masken erforderlich, um lokal zu beschichten. Ferner gibt es aufgrund des begrenzten Fassungsvermögens von Vakuumkammern Grenzen im Hinblick auf die Größe von Substraten bzw. Bauteilen, die beschichtet werden können.

Um diese Nachteile der Niederdruckverfahren zu vermeiden, wurden Atmosphärendruck-Plasmaverfahren vorgeschlagen.

Beispielsweise wird in der DE-A-199 58 473 eine Plasmastrahlquelle verwendet, von der gesagt wird, dass sie im Feinvakuum bis zum atmosphärennahen Druckbereich betrieben werden könne. Konkret beschrieben wird die gleichzeitige Abscheidung einer Matrixschicht und darin eingebetteter Partikel als Funktionsbeschichtung. Hierzu wird über die Gaszufuhr ein mikroskaliges oder nanoskaliges Metallpulver, wie TiN-Pulver gemeinsam mit einem Trägergas in das Plasma eingebracht.

Die DE-A-198 07 086 betrifft ein Verfahren zum Beschichten von Substratoberflächen in einem plasma-aktivierten Prozess bei Atmosphärendruck. Dabei wird eine Gasphase, die einen pulverförmigen Feststoff enthalten kann, in den Plasmastrahl eingebracht.

Auch in der WO 01/32949 wird ein Precursormaterial in den Plasmastrahl eingespeist, um so Oberflächen zu beschichten. Das Precursormaterial kann feste, beispielsweise pulverförmige Bestandteile enthalten. Damit lassen sich Partikel in die abgeschiedenen Schichten einbetten.

Atmosphärendruckverfahren wurden auch zur Modifizierung der Oberfläche von Partikeln eingesetzt. So wird in der
DE-A-10 2005 042 109 und der korrespondierenden WO 2007/028798 ein Verfahren zur Beschichtung von Partikeln eines Metallpulvers mit einer elektrisch isolierenden Schicht beschrieben. Es kann eine Atmosphärendruck-Plasmaquelle verwendet werden. Zur Beschichtung der Partikel wird das Plasma mit Monomeren und Metallpulver vermischt.

Sämtlichen zuvor beschriebenen Atmosphärendruck-Plasmaverfahren zur Erzeugung von Schichten mit darin dispergierten Partikeln bzw. Beschichtung von Partikeln ist gemeinsam, dass die Partikel, beispielsweise in Form von Pulvern, von außen in den Plasmastrahl eingespeist werden. Dieses Vorgehen bringt beträchtliche Probleme mit sich, wenn Mikropartikel und erst recht wenn Nanopartikel in Schichten eingebaut bzw. beschichtet werden sollen. Der Grund liegt darin, dass Mikropartikel und ganz besonders Nanopartikel, wenn sie in Form von Pulvern vorliegen, stark zur Agglomeration neigen.

Die DE-B-102 23 865 betrifft ein Verfahren zur Plasmabeschichtung von Werkstücken, bei dem mit Hilfe einer Plasmadüse durch elektrische Hochfrequenzentladung ein Strahl eines atmosphärischen Plasmas erzeugt wird, mit dem die zu beschichtende Werkstückoberfläche überstrichen wird. Das Verfahren ist dadurch gekennzeichnet, dass zumindest eine Komponente des Beschichtungsmaterials als Feststoff in einer Elektrode der Plasmadüse enthalten ist und durch die Hochfrequenzentladung von der Elektrode abgesputtert wird. Ausweislich der DE-B-102 23 865 liegt das abgesputterte Material vorwiegend in Form sehr reaktionsfreudiger Ionen oder Radikale vor. Diese Spezies bilden nach der Lehre dieses Patents homogene Beschichtungen, beispielsweise aus Metallen oder Metallverbindungen. Die Erzeugung von Partikeln, geschweige denn von Partikeln, die anschließend oberflächenmodifiziert werden, wird in der DE-B-102 23 865 nicht gelehrt.

Im Licht des zuvor diskutierten Standes der Technik standen die Erfinder daher vor der Aufgabe, Verfahren vorzuschlagen, die die erwähnten Probleme im Zusammenhang mit der Agglomeration von Partikeln vermeiden und die Herstellung von Beschichtungen mit darin fein dispergierten Mikro- und insbesondere Nanopartikeln bzw. auch modifizierter, insbesondere beschichteter Mikro- und Nanopartikel erlauben, und zwar bei Atmosphärendruck mit den damit verbundenen Vorteilen gegenüber Niederdruckverfahren, wie insbesondere der kostengünstigeren Verfahrensführung aufgrund der Entbehrlichkeit von Vakuumapparaturen, der Möglichkeit der lokalen Beschichtung ohne Verwendung von Masken und den höheren Abscheideraten im Bereich von µm/s.

### ZUSAMMENFASSUNG DER ERFINDUNG

Diese Aufgabe wird erfindungsgemäß durch das Atmosphärendruckplasmaverfahren zur Herstellung oberflächenmodifizierter Partikel gemäß dem unabhängigen Anspruch 1, sowie das Verfahren zur Herstellung von Beschichtungen mit darin dispergierten Partikeln gemäß dem unabhängigen Anspruch 5 gelöst. Mit dem Verfahren gemäß Anspruch 1 können Partikel, insbesondere mit einem Partikeldurchmesser in einem Bereich von Nanometern bis zu mehreren 10 Mikrometern oberflächenmodifiziert, beispielsweise beschichtet werden. Mit dem Verfahren nach dem unabhängigen Anspruch 5 lassen sich leicht Beschichtungen erzeugen, in denen Partikel, insbesondere solche im oben genannten Größenbereich, fein dispergiert sind.

Die Erfindung beruht auf dem überraschenden Befund, dass in Atmosphärendruckplasmaverfahren, beispielsweise solchen unter Verwendung einer Plasmadüse, Elektroden, zwischen denen das Plasma durch eine Entladung erzeugt wird, als Quelle für Partikel dienen können, die in situ in dem Plasma oberflächenmodifiziert, beispielsweise beschichtet, werden und so von einer Agglomeration abgehalten werden können. Alternativ können diese Partikel zusammen mit Beschichtungsvorläuferverbindungen unter Bildung einer Beschichtung, in die sie eingebaut sind, abgeschieden werden. Entsprechend betrifft die vorliegende Erfindung auch die Verwendung einer Entladung in einer Plasmadüse, insbesondere einer Atmosphärendruckplasmadüse, zum Absputtern von Partikeln aus mindestens einer Elektrode der Plasmadüse.

Der Stand der Technik, wie er durch die DE-B-102 23 865 repräsentiert wird, verwendete Elektrodenmaterialien als Komponenten homogener Beschichtungen, jedoch nicht als Quelle diskreter Partikel, die in dem Plasma in situ oberflächenmodifiziert werden können.

Als Elektrode im erfindungsgemäßen Sinn wird jeder Bestandteil der verwendeten Vorrichtung, insbesondere Plasmadüse, verstanden, der zumindest zeitweise Ausgangs- oder Endpunkt der Ladungsbewegung ist.

Auch betrifft die Erfindung ein Verfahren zur Herstellung von Verbundmaterialien, bei denen oberflächenmodifizierte Partikel, die mit dem erfindungsgemäßen Verfahren hergestellt wurden, in eine Matrix eingebaut werden, wobei die Oberfläche der Partikel dadurch modifiziert ist, dass sie mit einer Plasmapolymerschicht versehen ist, sowie die so erhältlichen Verbundmaterialien als solche.

Gemäß einem weiteren Aspekt betrifft die Erfindung eine spezielle Plasmadüse, die das Sputtern von Partikeln aus Elektroden, zwischen denen die Entladung brennt, ermöglicht und somit die Durchführung des erfindungsgemäßen Verfahrens zur Herstellung oberflächenmodifizierter Partikel erlaubt. Diese Plasmadüse ist in dem unabhängigen Anspruch 13 näher spezifiziert. Die Spannung zwischen der Elektrode und der Gegenelektrode, die vorzugsweise eine Hochspannung ist, wird dabei vorteilhaft durch einen Spannungsgenerator bzw. Hochspannungsgenerator erzeugt. Gemäß einer bevorzugten Ausführungsform ist die Spannung gepulst. In diesem Fall kommt als Spannungsgenerator ein Pulsgenerator zum Einsatz. Ferner werden auch Vorrichtungen vorgeschlagen, die eine solche Plasmadüse, sowie eine Einrichtung zum Einspeisen von chemischen Verbindungen in den Plasmastrahl umfassen. Diese Einrichtung befindet sich vorzugsweise außerhalb des Bereichs der Plasmadüse, in dem das Plasma erzeugt wird.

Bevorzugte Ausgestaltungen der erfindungsgemäßen Verfahren zur Herstellung oberflächenmodifizierter Partikel bzw. von Beschichtungen mit darin dispergierten Partikeln, der Plasmadüsen und der Vorrichtungen sind Gegenstand der abhängigen Ansprüche.

### KURZE BESCHREIBUNG DER ZEICHNUNGEN

In den beigefügten Figuren ist das erfindungsgemäße Verfahren zur Herstellung einer Beschichtung, in der die Partikel dispergiert sind, dargestellt. Die Figuren unterscheiden sich lediglich im Hinblick auf die zur Erzeugung der Partikel verwendeten Sputterelektroden. In Fig. 1 wird ein Draht als Sputterelektrode eingesetzt und in Fig. 2 eine Elektrode mit ausgeprägten Kanten. Gemäß der Verfahrensführung der Fig. 3 ist die Sputterelektrode eine rotierende Elektrode. Die Figuren erlauben ferner eine Illustration des erfindungsgemäßen Verfahrens zur Herstellung oberflächenmodifizierter Partikel.

### AUSFÜHRLICHE BESCHREIBUNG DER ERFINDUNG

In den erfindungsgemäßen Atmosphärendruckplasmaverfahren wird das Plasma durch eine Entladung zwischen Elektroden in einem Prozessgas erzeugt. Insoweit wird das Plasma auf eine Art und Weise erzeugt, wie sie beispielsweise in Atmosphärendruckplasmadüsen des Standes der Technik üblich war. Es sei beispielsweise auf die DE-A-195 32 412, die DE-U-299 21 694, die DE-U-299 11 974 und die WO 01/32949 verwiesen. Im Stand der Technik, wie er durch die o.g. Schriften repräsentiert wird, sollte indessen ein Absputtern von Elektrodenmaterial vermieden werden, und zwar aus verschiedenen Gründen. Zum einen sollte eine Verunreinigung der durch den Plasmastrahl zu reinigenden, zu aktivierenden oder zu beschichtenden Substratoberfläche durch Elektrodenmaterial vermieden werden. Darüber hinaus würde ein Absputtern von Elektrodenmaterial die Standzeit der Elektrode verringern. Um ein Absputtern von Elektrodenmaterial zu vermeiden, wurde daher in den Atmosphärendruckplasmen des Standes der Technik der Ausgangs- bzw. Endpunkt der Entladung, durch die das Plasma erzeugt wird, meistens ständig variiert, um einen lokal zu hohen Leistungseintrag pro Fläche in der Elektrode zu vermeiden, wodurch Material abgesputtert werden könnte. In der DE-B-102 23 865 wird gesagt, es komme zum Einbau von Elektrodenmaterial in homogene Beschichtungen. In dieser Schrift wird an die Erzeugung diskreter Partikel, die in situ oberflächenmodifiziert oder in Beschichtungen eingebaut werden können, nicht gedacht. Auf diesem Gedanken beruht indessen die vorliegende Erfindung. Es war auch nicht zu erwarten, dass sich durch ein solches Vorgehen die Agglomerationsprobleme mit Mikro- und Nanopartikeln im Stand der Technik vermeiden lassen und sich leicht nichtagglomerierte oberflächenmodifizierte, insbesondere beschichtete Mikro- und Nanopartikel, ganz besonders Nanopartikel, erhalten lassen bzw. Beschichtungen, in denen solche Partikel fein dispergiert eingebaut sind.

Unter einem "Atmosphärendruckplasma", auch als AD-Plasma oder Normaldruckplasma bezeichnet, versteht man ein Plasma, bei welchem der Druck ungefähr dem Atmosphärendruck entspricht. C. Tendero et al. geben in "Atmospheric pressure plasmas: A review"; Spectrochimica Acta Part B: Atomic Spectroscopy; 2005 einen Überblick über Atmosphärendruckplasmen. Die im erfindungsgemäßen Verfahren verwendbaren Atmosphärendruckplasmen können durch verschiedene Arten der Anregung erzeugt werden. In Frage kommen hier die AC (alternating current, Wechselstrom)-Anregung, die DC- (direct current, Gleichstrom) und Niederfrequenzanregung, die RF-Anregung und die Mikrowellenanregung. Gemäß einer besonders bevorzugten Ausführungsform werden die Atmosphärendruckplasmen durch eine gepulste Gleichspannung erzeugt. Wie die Erfinder überraschend festgestellt haben, lässt sich durch Erzeugung des Atmosphärendruckplasmas im erfindungsgemäßen Verfahren durch Gleichstrom die Sputterausbeute (also die Ausbeute an gesputterten Partikeln) gegenüber Wechselstromanregung signifikant steigern. Besonders vorteilhaft lässt sich eine solche gepulste Gleichspannung durch Zwischenschalten eines Gleichrichters zwischen Transformator und Elektrode erzeugen. Erfindungsgemäß ist es besonders vorteilhaft, wenn das Atmosphärendruckplasma ein Plasmastrahl ist, der insbesondere durch eine Plasmadüse erzeugt wird.

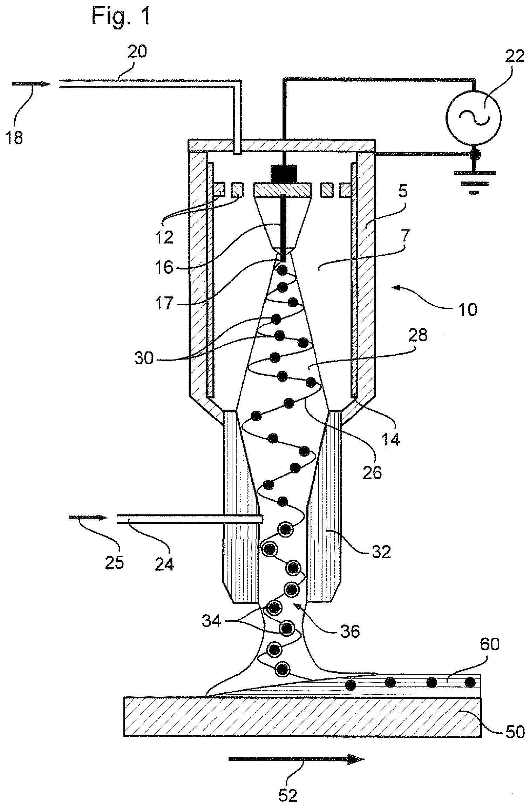

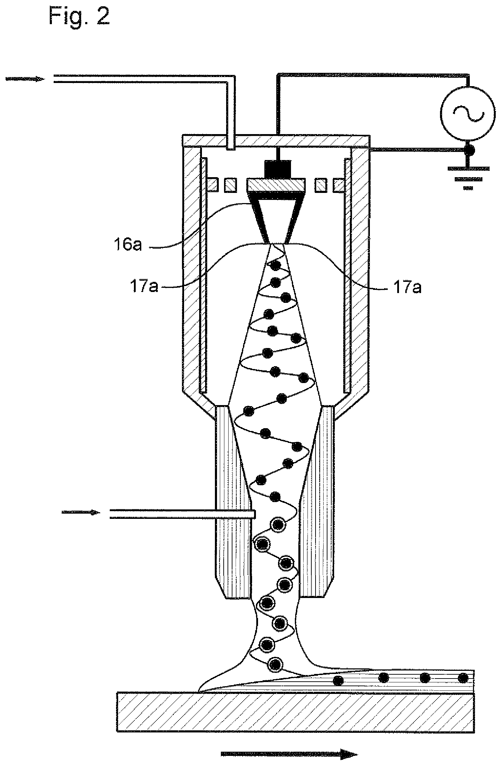

Im Sinne der vorliegenden Anmeldung wird die Elektrode, von der im erfindungsgemäßen Verfahren durch die plasmaerzeugende Entladung Partikel zerstäubt bzw. abgesputtert werden, als "Sputterelektrode" bezeichnet. In den erfindungsgemäßen Verfahren können mehrere Elektroden Sputterelektroden sein; jedoch ist vorzugsweise genau eine der Elektroden Sputterelektrode. Wenn beispielsweise das erfindungsgemäße Verfahren mit einer entsprechend adaptierten Plasmadüse bzw. einer Vorrichtung, die eine solche Plasmadüse umfasst, durchgeführt wird, kann die im Düsenkanal der Plasmadüse angeordnete Elektrode als Sputterelektrode fungieren. Diese im Düsenkanal der Plasmadüse angeordnete Elektrode ist in Fig. 1 mit dem Bezugszeichen 16 und in Fig. 2 mit dem Bezugszeichen 16a bezeichnet. Von dieser Elektrode geht die Entladung aus und endet an der Gegenelektrode, in den Plasmadüsen der Fig. 1 und 2 an dem geerdeten Düsenkopf 32.

Die erfindungsgemäßen Verfahren zur Herstellung oberflächenmodifizierter Partikel bzw. von Beschichtungen mit darin dispergierten Partikeln verlaufen besonders vorteilhaft, wenn die mittlere Sputterrate von der mindestens einen Sputterelektrode ≥ 10⁻⁵ cm³/min, mehr bevorzugt ≥ 10⁻⁴ cm³/min, noch mehr bevorzugt ≥ 10⁻³ cm³/min, am meisten bevorzugt ≥ 10⁻² cm³/min ist. Selbstverständlich hängt die mittlere Sputterrate von den verwendeten Elektrodenmaterialien ab.

Um derart hohe mittlere Sputterraten zu erreichen, kann im Falle ortsfester Sputterelektrode(n) die Entladung auf eine begrenzte, möglichst kleine Fläche der Sputterelektrode(n) konzentriert werden.

Dies kann insbesondere dadurch erreicht werden, dass die Sputterelektrode(n) mindestens einen Bereich aufweisen, der geometrisch ausgezeichnet ist. Unter einem geometrisch ausgezeichneten Bereich wird im Sinne der vorliegenden Anmeldung ein Bereich verstanden, in dem sich aufgrund der dort herrschenden hohen Feldstärke die Entladung konzentriert. Typische Beispiele solcher geometrisch ausgezeichneter Bereiche in Elektroden sind Spitzen und Kanten.

Beispielsweise kann die Sputterelektrode ein Draht sein, von dessen Ende die Entladung ausgeht. Besonders vorteilhaft ist es, wenn das Drahtende in Form einer Spitze vorliegt. Gemäß einer besonders bevorzugten Ausführungsform hat der Draht einen mittleren Durchmesser von 0,5 bis 5 mm, insbesondere 1 bis 3 mm. Aufgrund des Materialabtrags durch das Sputtern ist die Drahtsputterelektrode vorzugsweise nachführbar. In der vorliegenden Beschreibung bedeutet "nachführbar" im Zusammenhang mit einer Elektrode, dass der durch das Sputtern abgetragene Teil der Elektrode (hier des Drahtes) durch Nachschieben der Elektrode ersetzt werden kann.

Die Konzentration der Entladung auf einen begrenzten Bereich der Sputterelektrode(n) kann ferner durch die Gasströmung des Prozessgases begünstigt werden werden. Hier erweist sich beispielsweise eine gerichtete wirbelförmige Strömung des Prozessgases, die durch eine Drallvorrichtung erzeugt werden kann, als vorteilhaft.

Das Absputtern von Partikeln kann ferner durch Wahl eines leicht sputterbaren Elektrodenmaterials begünstigt werden. Silber ist beispielsweise ein solches besonders leicht sputterbares Material. Wie die Erfinder festgestellt haben, lassen sich mit Silberelektroden bereits brauchbare Sputterraten erreichen, wenn herkömmliche Elektrodengeometrien zum Einsatz kommen.

Andererseits kann durch einen zu hohen Leistungseintrag durch die Entladung bezogen auf die Fläche der Sputterelektrode(n) die lokale Temperatur an den Sputterelektrode(n) so groß werden, dass es zum Absputtern zu großer Partikel, insbesondere zu einem sogenannten Abspratzen von Material kommt. Daher ist es, um kleine Partikel, wie Mikro- und Nanopartikel abzusputtern, vorteilhaft, dass der Leistungseintrag durch die Entladung bezogen auf die Fläche der Sputterelektrode(n) einen bestimmten Maximalwert nicht überschreitet. Ein übermäßig großer Leistungseintrag und somit das Absputtern allzu großer Partikel kann in den erfindungsgemäßen Verfahren wie folgt vermieden werden.

Die erste Möglichkeit ist der gepulste Betrieb des Generators, mit dem die Entladung, bei der es sich vorzugsweise um eine Bogenentladung handelt, erzeugt wird. Die Pulsfrequenz des Generators ist nicht besonders beschränkt und kann 5 bis 70 kHz betragen, wobei der Bereich von 15 bis 40 kHz bevorzugt ist. Für die Durchführung der erfindungsgemäßen Verfahren erwiesen sich Pulsfrequenzen von 16 bis 25, insbesondere 17 bis 22 kHz als besonders vorteilhaft. Zur Erhöhung der Menge abgesputterter Partikel (Sputterausbeute) erwies sich eine Pulslänge von ≥ 3 µs als geeignet. Ferner zeigte sich, dass die Sputterausbeute gegenüber der Wechselstromanregung durch Einsatz einer pulsierenden Gleichspannung zur Erzeugung des Plasmas erhöht werden kann. Eine solche gepulste (oder pulsierende) Gleichspannung kann beispielsweise durch einen Gleichrichter zwischen Pulsgenerator (Trafo) und Düse erzeugt werden. Wie gezeigt werden konnte, ist bei Verwendung einer pulsierenden Gleichspannung insbesondere ein hoher Abtrag gesputterter Partikel von der negativ geschalteten Elektrode möglich. Schließlich lässt sich die Sputterausbeute, also die Menge der von der Sputterelektrode abgesputterten Partikel durch das Puls-Pause-Verhältnis der Entladung beeinflussen. Im erfindungsgemäßen Verfahren liegt das Puls-Pause-Verhältnis vorzugsweise im Bereich von 1:0,5 bis 1:1000, besonders bevorzugt im Bereich von 1:1 bis 1:20.

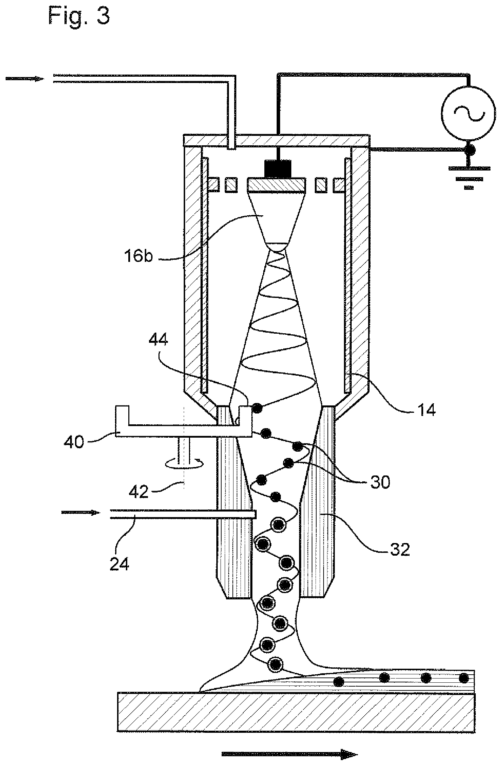

Eine zweite Möglichkeit besteht darin, dass man die mindestens eine Sputterelektrode rotieren oder oszillieren lässt. Durch die Rotation der Sputterelektrode kann erreicht werden, dass die Energie der Entladung nicht immer auf denselben Bereich der Sputterelektrode auftrifft. Dies lässt sich auch dadurch erreichen, dass man die Sputterelektrode(n) oszillieren lässt. Darunter wird erfindungsgemäß verstanden, dass man die Sputterelektrode(n) periodisch in den Bereich der Entladung hinein und aus ihm wieder hinaus bewegt. Um dennoch ausreichende Sputterraten zu erzielen, hat die rotierende oder oszillierende Elektrode vorzugsweise geometrisch ausgezeichnete Stellen, zu denen die Entladung aufgrund des elektrischen Feldes hingezogen wird. Die Entladung trifft also auf einen räumlich begrenzten Bereich auf. Beispielsweise kann die rotierende Gegenelektrode in Form eines Topfbohrers gestaltet sein. Dies ist in Fig. 3 gezeigt (Bezugszeichen 40).

Als Material der Sputterelektrode(n) und somit auch der abgesputterten Partikel kommen insbesondere Metalle (wie Kupfer und Silber), aber auch Metalllegierungen, Metalloxide (z.B. BaO) und Kohlenstoff in Frage. Im Hinblick auf die Anwendungen der mit dem erfindungsgemäßen Verfahren hergestellten oberflächenmodifizierten Partikel bzw. Beschichtungen mit darin dispergierten Partikeln sind die folgenden Materialien der Sputterelektrode(n) besonders bevorzugt: Silber, Zink, Zinkoxid, Magnesium, Kupfer, Zinn, Zinnoxid, Siliciumcarbid und Aluminiumbronze. Bei Verwendung einer Siliciumcarbid-Elektrode ließen sich beispielsweise SiOₓ/Glass-Partikel erhalten.

Wie sich aus dem oben Gesagten ergibt, werden die Sputterbedingungen in den erfindungsgemäßen Herstellungsverfahren vorteilhaft so gewählt, dass Mikro- und/oder Nanopartikel von der Sputterelektrode abgesputtert werden. In dieser Beschreibung werden unter Mikro- und Nanopartikeln Partikel verstanden, deren Durchmesser im Bereich von Nano- oder Mikrometern liegt. Vorzugsweise haben die Partikel einen Durchmesser in einem Bereich von 2 nm bis 20 µm. Gemäß einer besonders bevorzugten Ausführungsform handelt es sich um Nanopartikel, also um Partikel, deren Durchmesser im Nanometerbereich, insbesondere im Bereich von 2 bis 100 nm liegt. Ferner liegt auch der mittlere (volumengemittelte) Partikeldurchmesser der abgesputterten Partikel vorzugsweise im Bereich von Nano- oder Mikrometern, mehr bevorzugt im Bereich von 2 nm bis 20 µm, ganz besonders bevorzugt im Bereich von 2 bis 100 nm. Die Bestimmung der Korngröße von sehr kleinen Partikeln, wie Nanopartikeln, ist beispielsweise mit Laserstreungsverfahren oder Transmissionselektronenmikroskopie (TEM) möglich. Für größere Partikel stehen auch die Siebanalyse und zentrifugationsverfahren zur Verfügung. Beim im erfindungsgemäßen Sinne vorzugsweise zu vermeidenden Abspratzen von Material der Elektrode dagegen treten Partikeldurchmesser von >100 µm mit einem mittleren Partikeldurchmesser von > 50 µm auf.

In den erfindungsgemäßen Verfahren ist der Abstand zwischen den Elektroden, zwischen denen die Entladung erzeugt wird, nicht besonders beschränkt. Beispielsweise kann der Abstand zwischen 5 und 100 mm liegen. Im Hinblick auf die Menge abgesputterter Partikel (Sputterausbeute) erwies sich indessen ein Elektrodenabstand von vorzugsweise zwischen 8 und 50 mm als besonders vorteilhaft.

In dem ersten Aspekt des erfindungsgemäßen Verfahrens werden Partikel hergestellt, deren Oberfläche modifiziert ist. In der vorliegenden Anmeldung wird "Modifikation" in zweierlei weise verstanden. Erstens meint sie die Funktionalisierung der Oberfläche der Partikel. Bei der Funktionalisierung der Partikeloberfläche kommt es beispielsweise zu einem Austausch von Gruppen an der Oberfläche bzw. der Einführung und/oder dem Einbau funktioneller Gruppen oder auch von Atomen. Zweitens meint "Modifikation" die Beschichtung der Partikeloberfläche, also insbesondere das Aufbringen einer haftenden Schicht, beispielsweise einer Polymerschicht.

Die Modifizierung der Oberfläche der Partikel in dem Plasma kann dadurch erfolgen, dass eine chemische Verbindung in das Plasma eingespeist wird. Im Fall der Funktionalisierung der Partikel kann es sich bei der chemischen Verbindung um eine solche handeln, die im Plasma funktionelle Gruppen und/oder Atome in die Oberfläche der abgesputterten Partikel einbringt. Beispielsweise können hier Wasserstoff, Sauerstoff und Stickstoff-Wasserstoff-Verbindungen, insbesondere Amine genannt werden. Solche chemische Verbindungen können beispielsweise mit einer Einspeiseeinrichtung in den Plasmastrahl transportiert werden, die im Falle einer Plasmadüse beispielsweise unterhalb des Düsenausgangs angeordnet sein kann.

Die Modifizierung der Oberfläche der Partikel in dem Plasma kann auch durch das Prozessgas des Plasmas selbst erfolgen. In diesem Falle enthält das Prozessgas eine chemische Verbindung, mit der die Oberfläche der Partikel in dem Plasma modifiziert wird. Stickstoff als Prozessgas macht die Partikeloberflächen nitridisch, und Sauerstoff macht sie oxidisch. Oxidfreie Partikeloberflächen können beispielsweise durch Edelgase, insbesondere unter Zumischung von Wasserstoff, der mögliche Sauerstoffspuren in der Atmosphäre reduziert, erhalten werden.

Verwendbare Prozessgase, die beispielsweise in Plasmadüsen verwendet werden können, sind dem Fachmann geläufig. Beispielsweise können Stickstoff, Sauerstoff, Wasserstoff, Edelgase (insbesondere Argon), Ammoniak (NH₃), Schwefelwasserstoff (H₂S) und Mischungen davon, insbesondere Druckluft, Stickstoff-Wasserstoff-Gemische und Edelgas-Wasserstoff-Gemische zum Einsatz kommen. Wie sich zeigte, führt die Verwendung von Sauerstoff als Prozessgas gegenüber Stickstoff als Prozessgas zur Erzeugung von mehr Partikeln (Erhöhung der Sputterausbeute). Daher ist Sauerstoff als Prozessgas bevorzugt.

Die Durchflussmenge des Prozessgases durch das Atmosphärendruckplasma ist nicht besonders beschränkt und kann beispielsweise im Bereich von 300 bis 10000 1/h liegen. Da sich zeigte, dass geringere Durchflussmengen des Prozessgases tendenziell die Sputterausbeute erhöht, ist die Durchflussmenge erfindungsgemäß vorzugsweise im Bereich von 500 bis 4000 l/h.

Die abgesputterten Partikel werden im erfindungsgemäßen Verfahren vorzugsweise von dem Prozessgas transportiert.

Grundsätzlich kann die Modifizierung der Oberfläche der abgesputterten Partikel im Bereich des aktiven oder des relaxierenden Plasmas erfolgen. Unter einem "aktiven" Plasma wird allgemein ein Plasma verstanden, das sich innerhalb des Volumens findet, das von den Elektroden begrenzt wird, zwischen denen eine Spannung anliegt, durch die das Plasma erzeugt wird. Hingegen befindet sich der Bereich des relaxierenden Plasmas außerhalb der Anregungszone, die durch die genannten Elektroden begrenzt ist. Der Bereich des relaxierenden Plasmas wird gelegentlich auch als "after glow" - Bereich bezeichnet.

Bei einer Modifizierung der abgesputterten Partikel durch Einbringen chemischer Verbindungen in dem aktiven Bereich des Plasmas besteht die Gefahr, dass die Oberfläche der Elektroden modifiziert, beispielsweise beschichtet werden, wenn Beschichtungsvorläuferverbindungen als chemischen Verbindungen verwendet werden. Auch ist eine Vorreaktion, beispielsweise Vorpolymerisation von Beschichtungsvorläuferverbindungen im Bereich des aktiven Plasmas wahrscheinlicher.
Aus diesen Gründen ist es bevorzugt, dass die Oberflächenmodifizierung der abgesputterten Partikel im Bereich des relaxierenden Plasmas erfolgt.

In dem erfindungsgemäßen Verfahren zur Herstellung oberflächenmodifizierter Partikel ist eine ausreichende Verweilzeit der abgesputterten Partikel im Plasma in Kontakt mit den chemischen Verbindungen vorteilhaft, um den Grad der Oberflächenmodifizierung zu erhöhen. Typische Verweilzeiten sind 10⁻⁵ bis 10⁻¹ s. Diese Verweilzeit kann, beispielsweise wenn eine Plasmadüse verwendet wird, durch die Strömungsgeschwindigkeit des Prozessgases und die Weglänge zwischen der Stelle der Einspeisung der chemischen Verbindungen zur Oberflächenmodifizierung und der Stelle des Auffangens der Partikel, beispielsweise in einem inerten Medium, beeinflusst werden.

In dem Fall, dass die abgesputterten Partikel in dem Plasma beschichtet werden sollen, können sie in Kontakt mit einer Beschichtungsvorläuferverbindung gebracht werden.

Die Beschichtungsvorläuferverbindung kann eine solche sein, die im Atmosphärendruckplasma Beschichtungen, insbesondere polymere, ganz besonders plasmapolymere Beschichtungen um die Partikel herum ausbilden kann. Beispiele für Beschichtungsvorläuferverbindungen, die zu hydrophoben

Beschichtungen führen können, sind Hexamethyldisiloxan (HMDSO), Tetraethoxysilan (TEOS), Hexamethyldisilazan (HMDS), Acetylen, Maleinsäure, Ölsäure, Linolsäure und Linolensäure. Je nach den Plasmabedingungen und dem verwendeten Prozessgas - beispielsweise wenn sauerstoffhaltige Prozessgase, insbesondere Sauerstoff zum Einsatz kommen - können die genannten Beschichtungsvorläuferverbindungen auch zu eher hydrophilen Beschichtungen führen. Für hydrophilere Beschichtungen erwiesen sich Acrylsäure, Methacrylsäure und Methacrylsäuremethylester als geeignet. Für Beschichtungen mit stickstoffhaltigen Gruppen sind Pyrrol und Pyridin geeignet. Weitere Beispiele für verwendbare Beschichtungsvorläuferverbindungen für polymere Beschichtungen sind N-Trimethylchitosan, Benzochinon und Polyvinylpyrrolidon. Schließlich kommen als Beschichtungsvorläuferverbindungen Toluol, Cyclohexan, fluorhaltige Verbindungen (z.B. Dekafluorpentan), Thiophen, sowie ganz allgemein metallorganische Verbindungen in Frage.

Gemäß einer besonders bevorzugten Ausführungsform wird die Oberfläche der abgesputterten Partikel in dem Plasma, vorzugsweise dem relaxierenden Plasma, mit einer Plasmapolymerschicht, die zumindest einen Teil der Oberfläche von abgesputterten Partikeln bedeckt, versehen. Bei einer Plasmapolymerisation werden die Vorläuferverbindungen, hier die Beschichtungsvorläuferverbindungen, zunächst fragmentiert/ionisiert/angeregt und anschließend polymerisiert. Dies ist der Unterschied zu einer Polymerisation im herkömmlichen Sinne. Das Plasmapolymer ist das Produkt der Plasmapolymerisation der Beschichtungsvorläuferverbindungen.

Die mit dem erfindungsgemäßen Verfahren erhaltenen oberflächenmodifizierten Partikel können anschließend geeignet aufgefangen werden. Als Auffangmedien kommen dabei allgemein Polymere und Oligomere, wie beispielsweise Polyole, Vinylester, Epoxidharze, Urethane, Acrylate, und ferner, vorzugsweise niedermolekulare, Flüssigkeiten wie Wasser, Alkohole, Ketone, aliphatische und aromatische Lösungsmittel in Frage. Gemäß einer bevorzugten Ausführungsform kommt es nicht zu einer Reaktion zwischen den oberflächenmodifizierten Partikeln und dem Auffangmedium. Die Auffangmedien, insbesondere Flüssigkeiten, mit den darin dispergierten oberflächenmodifizierten Partikeln können direkt beispielsweise in Lacke, Klebstoffe und Kunststoffe eingebracht werden. Mithin können die in einem geeigneten Auffangmedium dispergierten oberflächenmodifizierten Partikel als Masterbatch zum Einsatz kommen. Ein Beispiel ist das Auffangen von mit dem erfindungsgemäßen Verfahren erhaltenen oberflächenmodifizierten Partikeln in einem Polyol, das als Masterbatch als zweiter Komponente einer polyisocyanathaltigen Mischung zugesetzt wird, um so ein Polyurethan mit darin dispergierten oberflächenmodifizierten Partikeln zu erhalten. Zur Verhinderung der Agglomeration der dispergierten oberflächenmodifizierten Partikel können dem Auffangmedium, insbesondere den Flüssigkeiten, Dispergierhilfsmittel, beispielsweise Tenside beigemischt sein. Wenn die oberflächenmodifizierten Partikel nur gelagert werden sollen, kommt als Auffangmedium auch Siliconöl in Frage.

Es versteht sich, dass im erfindungsgemäßen Verfahren zur Herstellung oberflächenmodifizierter Partikel, bei dem von Elektroden abgesputterte Partikel in situ modifiziert werden, unter Umständen ein Teil von Partikeln unmodifiziert bleibt. Eine Trennung der modifizierten von den unmodifizierten Partikeln kann mit üblichen Verfahren erreicht werden. Beispielsweise kommen die Zentrifugation, elektrostatische Separation oder chemische Fällungsreaktionen in Frage. Gemäß einer bevorzugten Ausführungsform erfolgt die Trennung des Gemischs der modifizierten und der unmodifizierten Partikel, insbesondere der beschichteten und unbeschichteten Partikel, auf Basis der unterschiedlichen Sedimentationsgeschwindigkeiten in einer Sedimentationsflüssigkeit. Entsprechend wird das Gemisch der modifizierten und unmodifizierten Partikel in die Sedimentationsflüssigkeit geleitet. Beispielsweise wird in dem Fall, dass das Verfahren zur Herstellung oberflächenmodifizierter Partikel in einer Plasmadüse erfolgt (wie später erläutert), der Gasstrom, der modifizierte und unmodifizierte Partikel enthält, in der Sedimentationsflüssigkeit aufgefangen. Die Sedimentationsflüssigkeit, die verwendet werden kann, ist nicht besonders beschränkt, solange darin die zu trennenden modifizierten und unmodifizierten Partikel eine deutlich unterschiedliche Sedimentationsgeschwindigkeit haben, so dass eine Abtrennung wie oben beschrieben möglich ist. Der Fachmann wird für ein zu trennendes System modifizierter und unmodifizierter Partikel die Sedimentationsflüssigkeit geeignet auswählen, indem er beobachtet, ob es in der gewählten Testflüssigkeit zu einer Trennung von Partikeln kommt und anschließend die abgesunkene Fraktion und andere Fraktion der Partikel analytisch, beispielsweise mit XPS, untersucht. Konkrete Beispiele für verwendbare Sedimentationsflüssigkeiten sind Wasser, Öle (z.B. Silikonöle), Alkohol (insbesondere niedere Alkohole wie Methanol, Ethanol und Propanol, ganz besonders Ethanol) und ammoniakalische Lösungen.

Die mit dem erfindungsgemäßen Verfahren hergestellten oberflächenmodifizierten Partikel, insbesondere die oberflächenfunktionalisierten Partikel können anschließend einer weiteren Reaktion in einem flüssigen Medium, also einer Nachfunktionalisation unterzogen werden. Typische Reaktanden sind hier Epoxyverbindungen, Vinylester, Isocyanate, Polyole, Amine, Karbonsäuren sowie Polymere und Polymervorstufen. Diese Reaktion kann auch direkt in der Sedimentationsflüssigkeit erfolgen. Dies ist eine besonders bevorzugte Ausführungsform.

Mit dem erfindungsgemäßen Verfahren hergestellte oberflächenmodifizierte Partikel lassen sich in verschiedenste Materialien einbauen. Als Beispiele seien Klebstoffe, Kunststoffe, Lacke, pharmazeutische Zubereitungen und Farben, sowie Einzelkomponenten oder Vorprodukte dieser Materialien genannt.

In dem Verfahren zur Herstellung einer Beschichtung mit darin dispergierten Partikeln bzw. dem Verfahren zur Beschichtung eines Substrats gemäß dem zweiten Aspekt der Erfindung, der in den beigefügten Figuren näher erläutert wird, ist es nicht erforderlich, aber auch nicht ausgeschlossen, dass die abgesputterten Partikel bereits beschichtet werden, wenn sie sich durch das Plasma bewegen. Beim Auftreffen der (ggf. zumindest teilweise beschichteten) abgesputterten Partikel und der im Plasma fragmentierten, ionisierten und/oder angeregten Beschichtungsvorläuferverbindungen auf das Substrat kommt es dann zur Bildung der Beschichtung mit darin dispergierten Partikeln. In den erfindungsgemäß hergestellten Beschichtungen mit darin dispergierten Partikeln liegen die Beschichtung (beispielsweise das Plasmapolymer), und die dispergierten Partikel als separierte Phasen vor.

In dem Verfahren zur Herstellung einer Beschichtung mit darin dispergierten Partikeln gemäß der vorliegenden Erfindung kann die Relativgeschwindigkeit zwischen der Plasmadüse, mit der das Atmosphärendruckplasma vorteilhaft erzeugt werden kann, und dem Substrat im Bereich von mm/s bis m/s liegen und kann beispielsweise bis zu 200 m/min betragen. Durch die genannte Relativgeschwindigkeit kann die Beschichtungsmenge pro Fläche eingestellt werden. In dem erfindungsgemäßen Verfahren zur Herstellung von Beschichtungen kann ferner der Abstand zwischen Düse und Substrat, der ebenso die Beschichtungsmenge pro Fläche beeinflusst, 1 mm bis mehrere cm, beispielsweise maximal 10 cm sein.

Für die mit dem erfindungsgemäßen Verfahren hergestellten Beschichtungen mit darin dispergierten Partikeln gibt es zahlreiche Anwendungen. Beispielsweise ist eine plasmapolymere Schicht, die darin dispergiert Silbernanopartikel enthält, als nicht-cytotoxische, antimikrobiell wirksame Beschichtung z.B. im Medizinsektor, für Haushaltsgeräte und in Hygieneartikeln einsetzbar. Eine Beschichtung für den aktiven Korrosionsschutz von Metallen, die jeweils edler sind als Zink bzw. Magnesium lässt sich erhalten mit einer erfindungsgemäß hergestellten Beschichtung, die darin dispergiert Zink- bzw. Magnesiumpartikel enthält. Eine plasmapolymere Schicht, die darin UV-absorbierende Partikel, wie ZnO enthält, ist als UVabsorbierender Kratzschutz verwendbar. Ferner können mit dem erfindungsgemäßen Verfahren leitfähige, transparente Schichten hergestellt werden. Auch Katalysatoranwendungen und der Einsatz der Beschichtungen als optische Beschichtungen, insbesondere Hochindex-Beschichtungen sind denkbar.

In den erfindungsgemäßen Verfahren kann die Agglomeration der abgesputterten Partikel, insbesondere Mikro- und Nanopartikel, besonders wirksam unterbunden werden, wenn die Verweilzeit der abgesputterten Partikel im Plasma, bevor sie oberflächenmodifiziert werden, möglichst kurz ist.

Die erfindungsgemäßen Plasmadüsen, wie sie in dem unabhängigen Patentanspruch 13 spezifiziert sind, können durch Umbau herkömmlicher Plasmadüsen, insbesondere Atmosphärendruckplasmadüsen, wie sie beispielsweise in DE-A-195 32 412, DE-U-299 21 694, DE-U-299 11 974 beschrieben sind, hergestellt werden. In solchen Plasmadüsen kann mindestens eine Elektrode als Sputterelektrode fungieren. Konkret kann das beispielsweise die nachführbare Drahtelektrode oder die rotierbare oder oszillierbare Gegenelektrode sein. Gemäß einer bevorzugten Ausführungsform ist in der erfindungsgemäßen Plasmadüse die rotierbare, oszillierbare oder nachführbare Gegenelektrode die Sputterelektrode. Besonders vorteilhaft ist es, wenn die rotierbare, oszillierbare oder nachführbare Gegenelektrode, die als Sputterelektrode fungiert, geerdet ist, während die Elektrode auf Hochspannung liegt. Dies vermeidet die Probleme der Aufrechterhaltung des elektrischen Kontakts der beweglichen Elektrode mit der Hochspannungsversorgung. Diese Plasmadüsen sind als solche für die Durchführung des erfindungsgemäßen Verfahrens zur Herstellung oberflächenmodifizierter Partikel geeignet, wenn ein Prozessgas verwendet wird, das im Plasma die Oberfläche der Partikel modifizieren, insbesondere funktionalisieren kann.

Zusätzlich können diese Plasmadüsen mit Einrichtungen zum Einspeisen chemischer Verbindungen, insbesondere Beschichtungsvorläuferverbindungen, in den Plasmastrahl versehen sein. Bei diesen Einrichtungen kann es sich beispielsweise um einen Aufsatz auf den Düsenausgang der Atmosphärendruckplasmadüse handeln, der eine Leitung aufweist, durch die die chemischen Verbindungen in das Plasma eingespeist werden können. Mit Vorrichtungen, die eine erfindungsgemäße Plasmadüse und solche Einrichtungen zum Einspeisen chemischer Verbindungen umfassen, können die erfindungsgemäßen Atmosphärendruckplasmaverfahren besonders vorteilhaft durchgeführt werden.

Im Folgenden werden Ausführungsbeispiele der Erfindung anhand der Zeichnungen näher erläutert. Die hier illustrierten Beispiele dienen zum Verständnis der Erfindung, jedoch nicht zur Beschränkung des in den anhängenden Ansprüchen definierten Schutzbereichs. Fig. 1 zeigt eine schematische Querschnittsansicht einer ersten Ausführungsform einer erfindungsgemäßen Plasmadüse, Fig. 2 zeigt eine schematische Querschnittsansicht einer zweiten Ausführungsform einer erfindungsgemäßen Plasmadüse, und Fig. 3 zeigt eine schematische Querschnittsansicht einer dritten Ausführungsform einer erfindungsgemäßen Plasmadüse.

Fig. 1 gibt eine schematische Darstellung des erfindungsgemäßen Verfahrens zur Herstellung einer Beschichtung mit darin dispergierten Partikeln unter Verwendung eines Atmosphärendruckplasmas, das durch eine Plasmadüse 10 erzeugt wird. Die Plasmadüse weist ein elektrisch leitfähiges Gehäuse 5, das vorzugsweise länglich, insbesondere rohrförmig ausgebildet ist, und einen elektrisch leitfähigen Düsenkopf 32 auf. Das Gehäuse 5 und der Düsenkopf 32 bilden einen von einem Prozessgas durchströmten Düsenkanal 7. In dem Düsenkanal ist die Sputterelektrode 16 angeordnet. In Fig. 1 ist als Elektrode ein Draht vorgesehen, der nachführbar ist. In den Düsenkanal ist ein Rohr 14 eines Isolatormaterials, beispielsweise ein Keramikrohr, eingesetzt. Mittels eines Pulsgenerators 22 wird eine Spannung zwischen der Elektrode 16 und dem Gehäuse 5/Düsenkopf 32 angelegt. Die Pulsfrequenzen des Generators 22 sind nicht besonders beschränkt und liegen vorzugsweise in den im allgemeinen Teil der Beschreibung genannten Bereichen. Zwischen den Pulsgenerator 22 und die Elektrode 16 kann vorteilhaft ein (in den Figuren nicht gezeigter) Gleichrichter geschaltet werden. Das Gehäuse 5 und der Düsenkopf 32 sind im dargestellten Beispiel geerdet. Das Prozessgas 18 wird durch eine Leitung 20 in den Düsenkanal 7 eingeleitet und zwar im gezeigten Beispiel so, dass es drallförmig durch den Kanal hindurchströmt. Die drallförmige bzw. wirbelförmige Strömung des Prozessgases ist durch die spiralartige Linie 26 veranschaulicht. Eine solche Strömung des Prozessgases kann durch eine Dralleinrichtung 12 erreicht werden. Dabei kann es sich um eine Platte mit Löchern handeln. Ferner kann durch geeignete Wahl des Prozessgases eine Modifizierung der abgesputterten Partikel erreicht werden. Dies wurde bereits zuvor im allgemeinen Teil der Beschreibung erläutert. Durch die Hochspannung wird eine Entladung, insbesondere eine Bogenentladung, von der Drahtelektrode 16 zu dem nicht mit der Isolationsschicht 14 bedeckten Teil des Gehäuses, hier dem Düsenkopf 32, gezündet. Durch die Entladung werden von der Spitze 17 der Elektrode 16 Partikel 30, vorzugsweise Mikro- und Nanopartikel, abgesputtert und mit der wirbelförmigen Gasströmung 28 weitertransportiert. Über die Leitung 24 werden Beschichtungsvorläuferverbindungen 25 zugeführt. Je nach Art der Beschichtungsvorläuferverbindung kommt ihre Einspeisung in das Atmosphärendruckplasma über die Leitung 24 in gasförmigem, flüssigem oder festem, pulverförmigem Zustand in Frage, wobei der gasförmige Zustand bevorzugt ist. Ggf. erfolgt der Transport der Beschichtungsvorläuferverbindung durch die Zuleitung 24 mit Hilfe eines Trägergases, wie beispielsweise Luft oder Stickstoff. HMDSO, TEOS und HMDS können beispielsweise als Gas zugeführt werden, das z.B. durch einen Verdampfer (nicht gezeigt) erzeugt wird.

Durch den Kontakt mit den Beschichtungsvorläuferverbindungen 25 wird zumindest ein Teil der Partikel 30 beschichtet und bildet beschichtete Partikel 34. Diese können direkt als solche aufgefangen werden, beispielsweise in einem geeigneten Medium wie Silikonöl. Dies ist in Fig. 1 nicht dargestellt.

Vielmehr zeigt Fig.1 ein Verfahren zur Herstellung einer Beschichtung mit darin dispergierten Partikeln. Im Düsenkanal stromabwärts der Eintrittsstelle der Leitung 24 für die Einspeisung der Beschichtungsvorläuferverbindungen sind sämtliche Partikel 34 als vollständig beschichtete Partikel, also Partikel mit Kern und Beschichtungshülle dargestellt. In der Realität mag indessen nur ein Teil der Partikel 30 von den Beschichtungsvorläuferverbindungen 25 unter Bildung einer Hülle beschichtet werden. Entscheidend ist es, dass sich beim Auftreffen des Plasmastrahls mit den darin enthaltenen Partikeln auf das Substrat 50 aus den Beschichtungsvorläuferverbindungen und den Partikeln eine Beschichtung 60 aus einer aus den Beschichtungsvorläuferverbindungen gebildeten Matrix mit darin dispergierten Partikeln 30 bildet. Wie durch den Pfeil 52 gezeigt, wird hierbei das Substrat 50 relativ zu der Plasmadüse 10 bewegt.

In Fig. 1 werden die Beschichtungsvorläuferverbindungen über die Leitung 24 in den Bereich des aktiven Plasmas eingespeist, das durch die Elektrode 16 und den als Gegenelektrode fungierenden Düsenkopf 32 eingegrenzt ist. Alternativ kann die Einspeisung über die Leitung 24 an einer Stelle zwischen dem Düsenausgang 36 und der Oberfläche des Substrats 50 in den Bereich des relaxierenden Plasmas erfolgen. Diese Ausführungsform ist bevorzugt, da damit eine Beschichtung der Gegenelektrode, hier des Düsenkopfs 32, vermieden werden kann.

Fig. 2 entspricht der Fig. 1 abgesehen davon, dass die Sputterelektrode, die dort als 16a bezeichnet ist, eine spezielle geometrische Form hat. Konkret handelt es sich um einen umgedrehten Kegelstumpf, an dessen Kanten 17a es zum Absputtern der Partikel 30 kommt.

Auch Fig. 3 entspricht der Fig. 1, mit wenigen Abweichungen. In Fig. 3 ist die Gegenelektrode die Sputterelektrode. Als Elektrode 16b, von der die Entladung ausgeht, kommt hier eine Elektrode zum Einsatz, wie sie herkömmlich in Plasmadüsen verwendet wird. An dieser Elektrode ist das Absputtern von Partikeln vernachlässigbar; dieses erfolgt ganz überwiegend an der Gegenelektrode 40, die um eine Achse 42 herum rotierbar ist. An der Kante 44 der Elektrode 40 werden durch die Entladung zwischen der Elektrode 16b und der Gegenelektrode 40 Partikel 30 abgesputtert, die mit dem Trägergasstrom weiter transportiert und die in Kontakt mit Beschichtungsvorläuferverbindungen gebracht werden, die über die Leitung 24 eingespeist werden. In Fig. 3 brennt die Entladung überwiegend zwischen der Elektrode 16b und der rotierenden Gegenelektrode 40, die geerdet ist. Diese Bevorzugung ergibt sich dadurch, dass die Kante 44 geometrisch ausgezeichnet ist und dort die elektrische Feldstärke besonders hoch ist.

Dennoch kann in der gezeigten Darstellung die Entladung zumindest zeitweise auch zwischen der Elektrode 16b und dem ebenfalls geerdeten Düsenkopf 32 verlaufen. Um die Entladungsbildung zwischen den Elektroden 16b und 40 und somit das Absputtern von Partikeln von der rotierenden Gegenelektrode weiter zu begünstigen, kann die Potentialdifferenz zwischen den Elektroden 16b und 40 im Vergleich zu der Potentialdifferenz zwischen der Elektrode 16b und dem Düsenkopf 32 weiter vergrößert werden. Eine weitere Möglichkeit besteht darin, die Isolation 14, die beispielsweise aus Keramik besteht, über den gesamten Innenbereich des Gehäuses, eingeschlossen die Innenseite des Düsenkopfs 32, zu führen und nur die rotierende Gegenelektrode unisoliert zu lassen. In diesem Fall kann die Entladung nur zwischen der Elektrode 16b und der rotierenden Sputterelektrode 40 verlaufen, was die Sputterraten an der rotierenden Gegenelektrode erhöht.

Anstelle der rotierenden Sputterelektrode 40 können auch eine oder mehrere geerdete, nachführbare Sputterelektroden 40, beispielsweise Drähte, wie sie im allgemeinen Teil der Beschreibung näher spezifiziert wurden, vorgesehen sein. Beispielsweise kommen hier radial zulaufende Drähte, zum Beispiel sechs Stück, im Bereich der rotierenden Sputterelektrode 40 in Frage. Dies ist der Fig. 3 nicht gezeigt.

## Patentansprüche

1. Verfahren zur Herstellung oberflächenmodifizierter Partikel in einem Atmosphärendruckplasma, wobei das Plasma durch eine Entladung zwischen Elektroden in einem Prozessgas erzeugt wird,
**dadurch gekennzeichnet, dass** mindestens eine der Elektroden eine Sputterelektrode ist, von der durch die Entladung Partikel abgesputtert werden, und dass anschließend die Oberfläche der Partikel in dem Plasma modifiziert wird.

2. Verfahren nach Anspruch 1, **dadurch gekennzeichnet, dass** die Oberflächenmodifizierung der abgesputterten Partikel im Bereich des relaxierenden Plasmas, erfolgt.

3. Verfahren nach Anspruch 1 oder 2, **dadurch gekennzeichnet, dass** die Oberfläche der Partikel dadurch modifiziert wird, dass die Partikel in Kontakt mit einer chemischen Verbindung gebracht werden.

4. Verfahren nach mindestens einem der vorhergehenden Ansprüche, **dadurch gekennzeichnet, dass** die Partikel in dem Plasma beschichtet werden.

5. Verfahren zur Herstellung einer Beschichtung mit darin dispergierten Partikeln unter Verwendung eines Atmosphärendruckplasmas, wobei das Plasma durch eine Entladung zwischen Elektroden in einem Prozessgas erzeugt wird,
**dadurch gekennzeichnet, dass** mindestens eine der Elektroden eine Sputterelektrode ist, von der durch die Entladung Partikel abgesputtert werden, und diese Partikel anschließend zusammen mit Beschichtungsvorläuferverbindungen auf einem Substrat abgeschieden werden und so eine Beschichtung mit darin dispergierten Partikeln gebildet wird.

6. Verfahren nach Anspruch 5, **dadurch gekennzeichnet, dass** die Beschichtung eine Plasmapolymerbeschichtung ist.

7. Verfahren nach mindestens einem der vorhergehenden Ansprüche, **dadurch gekennzeichnet, dass** die Entladung durch eine, vorzugsweise gepulste, Gleichspannung betrieben wird.

8. Verfahren nach mindestens einem der vorhergehenden Ansprüche, **dadurch gekennzeichnet, dass** die mittlere Sputterrate beim Absputtern der Sputterelektrode ≥ 10⁻⁵ cm³/min, vorzugsweise ≥ 10⁻⁴ cm³/min ist.

9. Verfahren mindestens einem der vorhergehenden Ansprüche, **dadurch gekennzeichnet, dass** die mindestens eine Sputterelektrode rotiert oder oszilliert.

10. Verfahren nach mindestens einem der vorhergehenden Ansprüche, **dadurch gekennzeichnet, dass** die abgesputterten Partikel eine Partikelgröße im Nanometer- bis Mikrometerbereich haben.

11. Verfahren zur Herstellung eines Verbundmaterials, bei dem mit einem Verfahren nach mindestens einem der Ansprüche 1 bis 4 hergestellte oberflächenmodifizierte Partikel in eine Matrix eingebaut werden, wobei die Oberfläche der Partikel dadurch modifiziert ist, dass sie mit einer Plasmapolymerschicht versehen ist.

12. Verbundmaterial, erhältlich mit einem Verfahren gemäß Anspruch 11.

13. Plasmadüse, die
ein Gehäuse, das einen von einem Prozessgas durchströmten Düsenkanal bildet,
eine im Düsenkanal angeordnete Elektrode und
eine im Düsenkanal angeordnete Gegenelektrode, umfasst, wobei eine Spannung, vorzugsweise eine Hochspannung, zwischen der Elektrode und der Gegenelektrode angelegt ist, um einen Plasmastrahl zu bilden, der aus dem Auslass des Gehäuses austritt, und
**dadurch gekennzeichnet ist, dass** die Gegenelektrode rotierbar, oszillierbar oder nachführbar ist.

14. Plasmadüse gemäß Anspruch 13, in der die Gegenelektrode geerdet ist.

15. Vorrichtung, die eine Plasmadüse wie in Anspruch 13 oder 14 definiert und eine Einrichtung zum Einspeisen von chemischen Verbindungen in den Plasmastrahl umfasst.

## Claims

1. Method for producing surface-modified particles in an atmospheric pressure plasma, wherein the plasma is generated in a process gas by a discharge between electrodes, **characterised in that** at least one of the electrodes is a sputter electrode, from which particles are sputtered by the discharge, and **in that** subsequently the surface of the particles is modified in the plasma.

2. Method according to claim 1, **characterised in that** the surface modification of the sputtered particles is effected in the region of the relaxing plasma.

3. Method according to claim 1 or 2, **characterised in that** the surface of the particles is modified **in that** the particles are brought into contact with a chemical compound.

4. Method according to at least one of the preceding claims, **characterised in that** the particles are coated in the plasma.

5. Method for producing a coating with particles dispersed therein using an atmospheric pressure plasma, wherein the plasma is generated in a process gas by a discharge between electrodes, **characterised in that** at least one of the electrodes is a sputter electrode, from which particles are sputtered by the discharge, and these particles are subsequently deposited on a substrate together with coating precursor compounds and hence a coating with particles dispersed therein is formed.

6. Method according to claim 5, **characterised in that** the coating is a plasma polymer coating.

7. Method according to at least one of the preceding claims, **characterised in that** the discharge is operated by a, preferably pulsed, direct-current voltage.

8. Method according to at least one of the preceding claims, **characterised in that** the average sputter rate during sputtering of the sputter electrode is ≥ 10⁻⁵ cm³/minute, preferably ≥ 10⁻⁴ cm³/minute.

9. Method according to at least one of the preceding claims, **characterised in that** the at least one sputter electrode rotates or oscillates.

10. Method according to at least one of the preceding claims, **characterised in that** the sputtered particles have a particle size in the nanometre range to micrometre range.

11. Method for producing a composite material, in which surface-modified particles produced using a method according to at least one of claims 1 to 4 are incorporated into a matrix, wherein the surface of the particles is modified in that it is provided with a plasma polymer layer.

12. Composite material which can be obtained using a method according to claim 11.

13. Plasma nozzle which comprises a housing, which forms a nozzle channel with process gas flowing through, an electrode arranged in the nozzle channel and a counter-electrode arranged in the nozzle channel, wherein a voltage, preferably a high voltage, is applied between the electrode and the counter-electrode to form a plasma jet which emerges from the outlet of the housing, and is **characterised in that** the counter-electrode can be rotated, oscillated or tracked.

14. Plasma nozzle according to claim 13, in which the counter-electrode is earthed.

15. Device which comprises a plasma nozzle as defined in claim 13 or 14 and a device for feeding chemical compounds into the plasma jet.

## Revendications

1. Procédé pour la fabrication de particules à surface modifiée dans un plasma à pression atmosphérique, le plasma étant produit par une décharge entre des électrodes dans un gaz de traitement,
**caractérisé en ce qu'**au moins une des électrodes est une électrode de pulvérisation, par laquelle, du fait de la décharge, des particules sont pulvérisées, et **en ce que** la surface des particules est ensuite modifiée dans le plasma.

2. Procédé selon la revendication 1, **caractérisé en ce que** la modification de surface des particules pulvérisées s'effectue dans la zone du plasma à action relaxante.

3. Procédé selon la revendication 1 ou 2, **caractérisé en ce que** la surface des particules est modifiée par le fait que les particules sont amenées en contact avec un composé chimique.

4. Procédé selon au moins l'une quelconque des revendications précédentes, **caractérisé en ce que** les particules sont revêtues dans le plasma.

5. Procédé pour la fabrication d'un revêtement comprenant des particules dispersées à l'intérieur en utilisant un plasma à pression atmosphérique, le plasma étant produit par une décharge entre des électrodes dans un gaz de traitement, **caractérisé en ce qu'**au moins une des électrodes est une électrode de pulvérisation, par laquelle, du fait de la décharge, des particules sont pulvérisées, et **en ce que** lesdites particules sont ensuite déposées sur un substrat conjointement avec des composés précurseurs de revêtement, et **en ce qu'**un revêtement comprenant des particules dispersées à l'intérieur est ainsi formé.

6. Procédé selon la revendication 5, **caractérisé en ce que** le revêtement est un revêtement par polymérisation au plasma.

7. Procédé selon au moins l'une quelconque des revendications précédentes, **caractérisé en ce que** la décharge est provoquée par une tension continue, de préférence pulsée.

8. Procédé selon au moins l'une quelconque des revendications précédentes, **caractérisé en ce que** le taux moyen de pulvérisation lors de la pulvérisation de l'électrode de pulvérisation est ≥ 10⁻⁵ cm3/min, de préférence ≥ 10⁻⁴ cm3/min.

9. Procédé selon au moins l'une quelconque des revendications précédentes, **caractérisé en ce que** l'au moins une électrode de pulvérisation tourne ou oscille.

10. Procédé selon au moins l'une quelconque des revendications précédentes, **caractérisé en ce que** les particules pulvérisées ont une taille de particule de l'ordre du nanomètre à l'ordre du micromètre.

11. Procédé pour la fabrication d'un matériau composite, où des particules à surface modifiée, fabriquées à l'aide d'un procédé selon au moins l'une quelconque des revendications 1 à 4, sont intégrées dans une matrice, la surface des particules étant modifiée par le fait qu'elle est pourvue d'une couche de polymérisation au plasma.

12. Matériau composite, pouvant être obtenu à l'aide d'un procédé selon la revendication 11.

13. Buse à plasma, qui comprend
un corps, qui forme un canal de buse traversé par un gaz de traitement,
une électrode disposée dans le canal de buse, et
une contre-électrode disposée dans le canal de buse, une tension, de préférence une haute tension, étant appliquée entre l'électrode et la contre-électrode afin de former un jet de plasma qui sort par la sortie du corps,
**caractérisée en ce que** la contre-électrode peut tourner, osciller ou être orientée.

14. Buse à plasma selon la revendication 13, où la contre-électrode est mise à la terre.

15. Dispositif, qui comprend une buse à plasma telle que définie dans la revendication 13 ou 14 et un dispositif servant à injecter des composés chimiques dans le jet de plasma.
